# EUROPEAN PATENT APPLICATION

(11) **EP 2 837 930 A1**
(43) Date of publication of application: **18.02.2015**
(21) Application number: 13180553.3
(22) Date of filing: 15.08.2013
(51) Int. Cl.: G01N 24/10, G01R 33/24, G01R 33/60, G01N 21/64

(54) **Method for detecting the magnitude of a magnetic field gradient**

(71) Applicant: Latvijas Universitate, 1586 Riga (LV)
(72) Inventor: Gahbauer, Florian Helmuth, LV-1048 Riga (LV); Ferbers, Ruvins, LV-1010 Riga (LV)
(74) Representative: Fortuna, Aleksandra

(57) **Abstract**

The invention relates to the field of measuring magnetic variables, more particularly, to the methods for detecting magnitude of a magnetic field gradient. The offered method comprises the steps of: (i) applying optical excitation radiation to a diamond containing one or more nitrogen-vacancy centers, thereby aligning the electronic spin or spins in a particular spin state; (ii) applying continuous RF radiation or pulses of RF radiation to the diamond containing one or more nitrogen-vacancy centers so as to induce transitions of the electronic spin state of the nitrogen-vacancy centers at specific values of the frequency of the RF radiation that depend on the magnetic field to be sensed; and (iii) detecting the intensity of the output optical radiation from the diamond containing one or more nitrogen-vacancy centers after the optical excitation radiation and the RF radiation have interacted with the electronic spins in the nitrogen-vacancy centers of the diamond, so as to determine the Zeeman shift and thus the magnetic field from the manner in which the intensity of the output radiation varies with the frequency of the applied RF radiation, wherein when detecting the output optical radiation from the diamond, the diamond is spatially modulated parallel with the optical axis to derive a signal proportional to magnetic field gradient, and the RF radiation to the diamond is frequency modulated in phase with the spatial modulation of the diamond to determine the exact magnitude of the gradient from the value of the frequency deviation of the frequency modulation at which the intensity of the optical output radiation no longer changes at the modulation frequency.

## Description

### Technical field

The invention relates to the field of measuring magnetic variables, more particularly, to the methods for detecting the magnitude of a magnetic field gradient.

### Background Art

The detection and measurement of magnetic field gradients is important in many scientific, technical, and medical applications. For example, magnetic field gradients give evidence of objects that may be hidden underground, in cargo, or on persons. Moreover, there is high demand and broad application prospects for high spatial resolution technologies in the field of chip quality control, topography of magnetic fluids and magnetic particles, and the study of biological objects at the cellular level.

There is known a method for increasing the sensitivity of a solid-state, electronic-spin based-magnetometer (WO 2009/073740), which makes use of individual electronic spins or ensembles of electronic spins in a solid-state lattice, for example NV centers in a diamond lattice. According to the method the electronic spins are configured to undergo a Zeeman shift in energy level when a magnetic field is applied. Photons of light are applied to polarize the spins in the ground state, followed by pulses of an RF field that is substantially transverse to the magnetic field being detected. Transitions between ground-state sublevels occur when the RF frequency matches the Larmor frequency of the spins, and these transitions are detected by monitoring the fluorescence light emerging from the diamond after irradiation by photons of light. Also the method includes coherently controlling the electronic spins by applying to the electronic spins a sequence of RF pulses that dynamically decouple the electronic spins from mutual spin-spin interactions and from interactions with the lattice. In order to measure gradients of the magnetic field, the method requires imaging the spins by means of a CCD camera or other imaging device or the application of additional magnetic field gradients or atomic force microscopy. These requirements add complexity or cost. Moreover, the gradient is not measured directly, but must be determined by further processing of the signals that contain information about the background magnetic field, which may not be of interest for a particular application. There is known an optical atomic magnetometer that operates on the principles of nonlinear magneto-optical rotation (WO 2009/073256). An atomic vapor is optically pumped using linearly polarized modulated light. The vapor is then probed using a non-modulated linearly polarized light beam. The resulting modulation in polarization angle of the probe light is detected and used in a feedback loop to induce self-oscillation at the resonant frequency.

There are known various magnetic gradiometers that are based on two or more magnetometers operated simultaneously and in close proximity (WO 1998040757 A1; US 6339328; US 5670082A; EP 0966689; US 3649908). There is known a method for measuring magnetic field gradients using an optical pumping technique that involves several lasers and two magnetic field measuring regions in a vapour of atoms or ions (US 8432162).

The drawbacks of the methods described in WO 2009/073256, WO 1998040757 A1, US 6339328, US 005670082A, EP 0966689B1, US 3649908, and US 8432162 is that two or more magnetic field measuring devices are required. Duplication of the magnetic field measuring device increases complexity and cost. It would be desirable to develop a simple method based on a single magnetic field measuring device that could produce a signal proportional to the gradient of the magnetic field magnitude in one or more directions.

### Disclosure of the invention

The aim of the invention is to improve the prior art methods for detecting the magnitude of a magnetic field gradient. The set aim is achieved by offering a method for detecting the magnitude of a magnetic field gradient by means of NV centers in diamonds comprising: applying optical excitation radiation to a diamond containing one or more nitrogen-vacancy centers, thereby aligning the electronic spin or spins in a particular spin state; applying continuous RF radiation or pulses of RF radiation to the diamond containing one or more nitrogen-vacancy centers so as to induce transitions of the electronic spin state of the nitrogen-vacancy centers at specific values of the frequency of the RF radiation that depend on the magnetic field to be sensed; and detecting the intensity of the output optical radiation from the diamond containing one or more nitrogen-vacancy centers after the optical excitation radiation and the RF radiation have interacted with the electronic spins in the nitrogen-vacancy center or centers of the diamond, so as to determine the Zeeman shift and thus the magnetic field from the manner in which the intensity of the output radiation varies with the frequency of the applied RF radiation, wherein when detecting the output optical radiation from the diamond, the diamond is spatially modulated parallel with the optical axis to derive a signal proportional to magnetic field gradient, and the RF radiation to the diamond is frequency modulated in phase with the spatial modulation of the diamond to determine the exact magnitude of the gradient from the value of the frequency deviation of the frequency modulation at which the intensity of the optical output radiation no longer changes at the modulation frequency. When applying continuous RF radiation or pulses of RF radiation to the diamond, the RF frequency may be subjected to an amplitude modulation with a square-wave envelope at a frequency f and the signals observed at 2f demodulation. The spatial modulation may be applied simultaneously in three mutually perpendicular directions and the gradient of a particular magnetic field component - determined in three directions simultaneously, so as to obtain the spatial gradient of a particular magnetic field component along three orthogonal axes simultaneously. Furthermore each orthogonal axis may be modulated with a different frequency and demodulated at that frequency.

### Example of implementation of the invention

A diamond crystal containing NV centers is mounted on a piezo table. The standard optical setup is used: light from a 532 nm laser is reflected onto the diamond sample by a long-pass dichroic mirror with cut-off at 567 nm. Red fluorescence from the diamond sample passes through this mirror into a photo-detector. A thin wire at the surface of the diamond sample is connected to an RF generator. A confocal microscope is used to limit sensitivity to a thin layer of the diamond.

To determine the ambient magnetic field, an RF frequency (from 2.6 to 3.0 GHz) is applied to the wire over the diamond crystal. The RF frequency is slowly scanned until a minimum of the fluorescence signal is found. The frequency at which this minimum occurs is directly related to the magnetic field value. To facilitate finding this minimum in an automated or semi-automated manner, the RF frequency may be subjected to an amplitude modulation with a square-wave envelope at several tens or hundreds of kilohertz (from 50 kHz to 1 MHz or even higher) and the fluorescence signal lock-in detected with the frequency of the amplitude modulation frequency as the reference signal in 2f mode. A computer directs the frequency scan to search for a zero in the lock-in output, which corresponds to the minimum value in the fluorescence.

To detect the magnetic field gradient the RF frequency is maintained at the same frequency corresponding to the fluorescence minimum, but without amplitude modulation. A sinusoidal signal is now applied to the piezo drive of the diamond table, taking care to move the diamond parallel with the optical axis. The amplitude of this modulation can be from 20 nm to 100 micrometers, depending on the level of gradient one wishes to detect. The frequency could be on the order of 100 Hz. The output of the photodetector is fed to the lock-in amplifier, and the reference frequency of the lock-in amplifier should be derived from the piezo modulation in If mode. The output of the lock-in amplifier will be directly related to the magnitude of the magnetic field gradient. This modulation could be applied simultaneously in three perpendicular directions. Each axis could be modulated with a different frequency and demodulated at that frequency. Thus, the gradient of a particular magnetic field component can be determined in three directions simultaneously.

To determine the magnitude of the magnetic field gradient, frequency modulation is now applied to the RF signal in phase with the mechanical modulation of the diamond crystal. The amplitude of the frequency modulation is varied until the output of the lock-in detection vanishes. The amplitude of the frequency modulation is directly related to the gradient.

### Sources of Information

1. Optical magnetometry with nitrogen-vacancy centers in diamond. V.M. Acosta, D. Budker, P.R. Hemmer, J.R. Maze, and R.L. Walsworth, in Optical Magnetometry, edited by D. Budker and D. F. Jackson Kimball (Cambridge University Press, Cambridge, UK, 2013), pp. 142-166.
2. Nanoscale magnetic imaging of a single electron spin under ambient conditions. M. S. Grinolds, S. Hong, P. Maletinsky, L. Luan, M. D. Lukin, R. L. Walsworth, A. Yacoby. Nature Physics 9, 215 (2013).
3. Nanoscale magnetometry with NV centers in diamond. S. Hong, M. S. Grinolds, L. M. Pham, D. Le Sage, L. Luan, R. L. Walsworth, A. Yacoby. Materials Research Society Bulletin 38, 155 (2013).

## Claims

1. A method for detecting the magnitude of a magnetic field gradient comprising the steps of:
(i) applying optical excitation radiation to a diamond containing one or more nitrogen-vacancy centers, thereby aligning the electronic spin or spins in a particular spin state;
(ii) applying continuous RF radiation or pulses of RF radiation to the diamond containing one or more nitrogen-vacancy centers so as to induce transitions of the electronic spin state of the nitrogen-vacancy centers at specific values of the frequency of the RF radiation that depend on the magnetic field to be sensed; and
(iii) detecting the intensity of the output optical radiation from the diamond containing one or more nitrogen-vacancy centers after the optical excitation radiation and the RF radiation have interacted with the electronic spins in the nitrogen-vacancy centers of the diamond, so as to determine the Zeeman shift and thus the magnetic field from the manner in which the intensity of the output radiation varies with the frequency of the applied RF radiation, wherein when detecting the output optical radiation from the diamond, the diamond is spatially modulated parallel with the optical axis to derive a signal proportional to magnetic field gradient, and the RF radiation to the diamond is frequency modulated in phase with the spatial modulation of the diamond to determine the exact magnitude of the gradient from the value of the frequency deviation of the frequency modulation at which the intensity of the optical output radiation no longer changes at the modulation frequency.

2. The method according to claim 1, wherein when applying continuous RF radiation or pulses of RF radiation to the diamond at the step (ii) the RF frequency is subjected to an amplitude modulation with a square-wave envelope at a frequency f and the signals are observed at 2f demodulation.

3. The method according to claim 2, wherein the amplitude modulation is applied simultaneously in three mutually perpendicular directions and the gradient of a particular magnetic field component is determined in three directions simultaneously, so as to obtain the spatial gradient of a particular magnetic field component along three orthogonal axes simultaneously.

4. The method according to claim 3, wherein each orthogonal axis is modulated with a different frequency and demodulated at that frequency.

5. The method according to any proceeding claims, wherein when detecting the output optical radiation from the diamond, the diamond is spatially modulated parallel with the optical axis with an amplitude from 20 nm to 100 micrometers.

6. The method according to any proceeding claims, wherein the RF frequency is subjected to an amplitude modulation with a square-wave envelope at a frequency f from 50 kHz to 1 MHz.
